# EUROPEAN PATENT SPECIFICATION

(11) **EP 0 983 320 B1**
(45) Date of publication and mention of the grant of the patent: **21.09.2005**
(21) Application number: 98923572.6
(22) Date of filing: 20.05.1998
(51) Int. Cl.: C08L 63/00, C08G 59/24

(54) **CURABLE SEALANT COMPOSITION**
HÄRTBARE DICHTUNGSMITTELZUSAMMENSETZUNG
COMPOSITION DE MASTIC DURCISSABLE

(30) Priority: 21.05.1997 US 47290 P; 24.03.1998 US 79204 P
(43) Date of publication of application: 08.03.2000
(73) Proprietor: Denovus L.L.C., Excelsior Springs, MO 64024 (US)
(72) Inventor: PACHL, Jeffrey, T., Holt, MO 64048 (US); TAYLOR, Donald, Liberty, MO 64069 (US); SCRIVENS, Todd, W., Lawson, MO 64062 (US)
(74) Representative: Brookes Batchellor
(86) International application number: PCT/US1998/010320
(87) International publication number: WO 1998/053008

(56) References cited:
- EP-A- 0 764 690
- US-A- 4 874 798

## Description

The instant invention relates to a novel composition, methods for applying the composition as well as end-uses for the cured composition.

Sealants are employed in a wide range of applications. In the automotive industry sealants are located between and upon metal seams and welds, within hollow cavities to impart structural and sound damping characteristics, among other locations. One example of an automotive sealant is utilized upon the welds in the so-called "roof-ditch" which is formed when joining the side panels of the body to the roof. The roof-ditch weld is conventionally covered with a strip of polyvinyl chloride (PVC) based molding which typically is covered with a metal strip and painted. The PVC strip typically contains plasticizers, stabilizers, lubricants, among other compounds that can volatilize from the strip thereby causing cracking and shrinking. When the PVC strip cracks such can reduce the effectiveness of the strip and in turn allow the underlying metal to corrode.

Conventional sealants including those employed in roof ditches can also create conditions which are conducive to microbial, e.g., fungal, growth; especially in warm humid environments. The microbe growth occurs because the sealant contains substances that can be metabolized by the microbe. Consequently, there is a need in the sealant industry for a sealant with enhanced durability, and microbial resistance and cosmetic value that can be applied in an expedient manner. There is also a need in this industry for a sealant that can be repaired or replaced.

Methods for applying and curing/heating coatings are described in U.S. Patent Nos. 4,844,947 (Kasner et al.). 5,348,604 (Neff) and 5,453,451 (Sokol). The disclosure of the previously identified patents is hereby incorporated by reference.

The instant invention solves problems associated with conventional practices by providing a radiation curable composition, which can be employed as a sealant that is easy to manipulate, durable, paintable, repairable/replaceable, crack and microbe resistant. The inventive composition can be employed in a wide range of end-uses including in the automotive industry, e.g., as a roof-ditch sealant. The composition of the invention can be applied by using commercially available dispensing equipment, e.g., spraying or pumping, and cured in-situ by a source of UV radiation. If desired, the inventive composition can be painted. The inventive composition comprises or consists essentially of at least one epoxy, at least one polyol, at least one thickener or filler, one or more suitable photoinitiators and optionally at least on monomer and/or phenoxy resin.

The subject matter of the instant invention is related to WO 98/52997 filed on even date herewith in the name of Jeffrey Pachl et al., and entitled "Novel Foaming Composition and Methods for Making and Using the Compositions".

EP-A-0764690 describes light-initiated, cationically hardened, permanently flexible epoxy resin materials (I), containing (A) cycloaliphatic epoxide compounds, (B) polyol(s) selected from polyester-, polycarbonate- and polybutadiene-polyols, (C) a metallocene salt with a complex anion having a nucleophilic property equal to or less than that of the SbF₆ anion, (D) an oxidative accelerator, (E) a polyvinyl acetal; and (F) fillers, pigments, stabilisers, complexing agents, initiators, thixotropic agents and/or thickeners.

US-4874798 describes photocopolymerizable compositions comprising a cycloaliphatic epoxy, a polycaprolactone polyol; an onium salt photoinitiator and, as a reactive diluent, a vinylcyclohexene monoepoxide. The photocopolymerizable compositions have low viscosity and can be applied to suitable substrates by conventional methods and, after being cured to dry coating films, can have utility as automative finishes, can finishes, appliance finishes, general metal finishes, adhesives, printing inks and the like.

In one aspect, the present invention provides a radiation curable composition as claimed in claim 1. In a second aspect, the present invention provides a method for treating an automative component joint or seam as defined in claims 17, 18 or 19.
Figure 1 is a schematic drawing of an apparatus which can be used for applying the inventive composition by using robotic means.
Figure 2 is a schematic drawing of the apparatus illustrated in Figure 1 as the inventive composition is applied.

The inventive composition comprises or consists essentially of 1) at least one epoxy such as that supplied by UCB Radcure as Uvacure 1500, 1530, and 1534 or by Sartomer as SARCAT K126, 2) at least one and (optionally two or more) normally two polyols such as the polyester polyols supplied by Union Carbide as Tone 0301 and by Huls America as Dynacoll 7110, optionally 3) at least one thickener or filler such as silicon dioxide supplied by Cabot Corporation; and 4) at least one photoinitiator such as sulfonium salt supplied by Union Carbide as Cyracure UVI 6974 and by Sartomer as CD1010; and 5) at least one phenoxy resin such as phenoxy resin such as paphen phenoxy resin PKHP 200 supplied by Phenoxy Specialties.

While any suitable epoxy or mixtures thereof can be employed in the inventive composition, a liquid cationic curing epoxy such as a cycloaliphatic epoxy is desirable. Normally, the epoxy corresponds to about 40 to about 90 wt.% and preferably about 45 to about 60 wt.% of the composition prior to curing. Without wishing to be bound by any theory or explanation, it is believed that the inventive composition employs a cationic reaction, which can be photoinitiated, that continues as a cascade reaction; especially if heated. It is also believed that when the inventive composition is exposed to a source of UV radiation/light a relatively thin skins forms substantially instantaneously upon the surface of the composition. The surface skin serves to stabilize the shape of the composition until the remainder of the composition has reacted, e.g., cross-linked, into a self-supporting structure. The thickness of the skin as well as the resultant article can be tailored to satisfy a particular end-use. e.g. an article having a thickness of from about 0.05 to about 10 mm as well as forming a skin upon an underlying uncured material.

The effectiveness of the aforementioned epoxy is enhanced by the presence of at least one polyol. By employing two or more polyols (in combination with at least one epoxy), the properties of the inventive composition can be tailored. Examples of properties that can be tailored include glass transition point, viscosity, adhesion to the underlying substrate (e.g., in the case of a roof ditch the automotive E-coat), degree of cross-linking in the cured composition, flexibility, among other desirable properties. The amount of polyol in the composition prior to curing ranges from about 5 to about 30 wt.%. While any suitable polyol can be employed, examples include polyether polyols and polyester polyols such as those supplied commercially by Union Carbide, Huls America and Arco. The epoxy to polyol ratio can range from about 1:1 to about 2:1.

At least one thickener or filler can be included as a component of the inventive composition. The amount of thickener normally corresponds to about 0.5 to about 5.0 wt.% of the composition prior to curing. While any suitable thickener can be employed fumed or aerosil silica can be used to obtain desirable results, e.g., fumed silicas commercially supplied by Cabot Corporation (M-5 Grade) and Degussa. Normally, precipitated silica is not employed. The thickener is typically non-reactive and employed to create a thixotropic fluid, e.g., having a viscosity of about 20,000 to about 80,000 centipoise. Consequently, the thickener can be admixed into the composition in any expedient manner, e.g., added to the polyol and vacuum mixed. If desired, the thickener can comprise a treated silica such as a silica having a silane surface treatment, e.g., TS720 supplied by Cabot Corporation.

The aforementioned photoinitiator is employed for inducing an interaction among one or more components of the inventive composition, e.g., epoxy and polyol. The amount of photoinitiator normally corresponds to about 0.5 to about 2 wt.% of the composition prior to curing. While any suitable photoinitiator or mixtures thereof can be employed, desirable results have been obtained by using a sulfonium salt, triarylsulfonium hexafluoroantimonate, diaryliodonium hexafluoroantimonate, mixtures thereof among others.

In one aspect of the invention, the photo initiator is partially or completely replaced by an acid such as at least one member selected from the group consisting of a suitable Lewis acid such as at least one member selected from the group consisting of sulfonic acids, phosphoric acid, citric acid, carboxylic acid, tannic and oxalic acids, and mixtures thereof, among others. Normally, the best results are obtained by using a source of phosphoric acid. In this aspect of the invention, the composition is employed in a two component system wherein the epoxy and acid are kept separated until it is desirable to produce a self supporting coating or an article. The epoxy and/or acid can be admixed with other components of the inventive composition, e.g., the acid can be admixed with a polyol. When the epoxy and acid are contacted a reaction occurs that is substantially similar to the one described herein when a photoinitiator is exposed to UV radiation. The amount of acid normally corresponds to about 0.25% to about 3.0% wt.% of the composition prior to curing.

Depending upon the inventive composition and particular end-use of a substrate which is coated with the inventive composition, one or more of the following additives can be included in the inventive composition: bis-F epoxy, thickeners, fillers, surfactants, pH indicators, biocides/antifungal compounds, solvents, fire extinguishants, PVC, PTFE, among other compounds which do not adversely impact curing. When employing a UV curable system, best results are obtained by avoiding materials that affect UV light transmission whereas the two component system can include a wider range of materials such as dyes, pigments. UV light stabilizers, among others. If desired, the inventive composition can include fibers, platelets, particles, among other components in order to form a composite article. Typically, the amount of such additives will range from about 1 to about 15 wt percent of composition prior to curing. Normally, it is desirable to minimize the presence of basic materials and/or those which affect UV transmittance when a UV curable system is employed.

The uncured composition can be obtained by any suitable means for admixing or combining the components of the composition. Normally, at least one of the epoxy or polyol will be heated to a temperature that is effective for increasing the rate at which the thickener, e.g., silica, can be dispersed. Bubbles formed during the mixing process can be removed by pulling a vacuum on the mixture. Greater details regarding the mixing process can be found in the forthcoming Examples.

The inventive composition can be applied and cured effectively at ambient temperatures, e.g., 18-35°C (about 65 about 95°F), thereby obviating the need to heat the composition during application. In some cases, however, it may be desirable to monitor and control the curing temperature if ambient temperatures are extreme. By obviating the requirement for heat curing, the instant invention permits utilization of unheated dispensing equipment as well as application upon unheated substrates. While heating is not necessary to apply the composition, once applied the UV cured composition can be baked or heated for improving the adhesion of the composition to the underlying substrate. For example, a source of infrared energy can be employed in combination with a UV lamp.

Curing of the inventive composition can be initiated via a source of ultraviolet light (UV). That is, while curing can be initiated by naturally occurring UV light, normally, a man-made source of UV is employed, e.g., to cross-link the polymeric matrix. The source of UV radiation can range widely such as a lamp mounted above a conveyor, a lamp mounted on a robot arm, a series of lamps mounted in a gantry located above or adjacent to a robot that dispenses the composition, among other apparatus for supplying UV radiation. After applying the inventive composition upon a suitable substrate, the composition can be exposed to a high output source of UV light (approx 2.5 J/cm² @ 365 nm, which may vary with exposure time, distance from source and type of bulb), that initiates curing thereby locking or freezing the composition as a coating upon the substrate. The specific wavelength of UV can be tailored to satisfy a wide range of product uses, exposure times and distance from the composition to be cured: but, normally ranges from greater than about 250 to about 400nm and having an output of about 2.5 to about 4.0 J/cm2. In some cases, it is desirable to employ one or more UV sources that emit differing UV wavelengths either simultaneously or sequentially, e.g., lamps that emit differing wavelengths and/or by one type of lamp having a filter. Examples of suitable UV curing systems and lamps are Model F600 System, "D", "S" and "H" lamps all of which are supplied by Fusion Systems Corporation, Rockville, Maryland.

The exposure time of the inventive composition to the UV source is typically about 1 to about 10 seconds. The specific exposure time can be tailored depending upon the distance from the UV source, intensity of the source, relative speed between the composition to be cured and the UV source, among other parameters. As described above, the source of UV can be supplied by any suitable means such as a conveyor, UV lamp such as a Fusion Systems "H" bulb attached to or associated with an arm of a robot which dispenses uncured composition, e.g., as a bead within a roof ditch or a spray upon a substrate. Consequently, the inventive composition can be readily employed in conventional fabrication or manufacturing processes. Typically, a safety curtain or booth, which surrounds the UV source, is desirable for minimizing any impact upon personnel. When the composition is employed in automotive applications such as a roof ditch, the UV curing step can be followed by a thermal bake, which enhances formation of a permanent adhesive bond to the underlying surface, e.g., an electrocoat (E-Coat), and improves the final curing of the sealant's polymer matrix. The thermal bake is typically conducted at a temperature greater than about 171°C (340 °F) and less than that which adversely impacts the coated substrate. While a thermal bake is not required for all applications of the inventive compositions, such a thermal bake can enhance the adhesion between the inventive composition and the underlying surface, and if desired can be employed in conjunction with UV exposure.

The inventive composition also has the ability to cure with ultraviolet rays from the sun. While the sun can be employed as a source of UV radiation, the cure time is relatively long in comparison to curing with concentrated/high energy UV sources. Examples of applications that can employ natural UV curing include the building/construction industry such as roof panel joints for metal building, skylight seals, concrete/cement sealants, drywall joint-compound ("mud"), among other applications exposed to natural UV radiation. For example. the inventive composition can be applied upon concrete/cement and cured in natural UV to form a water-proof paintable coating, e.g., an interior or exterior basement sealant and a swimming pool liner or seal.

Subsequent operations to the coated substrate will typically not disturb the coating, e.g., when the coating is employed as an automotive roof ditch sealant the coating will not drip or run during subsequent manufacturing steps such as painting. The long term dimensional stability of the cured inventive composition is improved in comparison to conventional PVC sealant compositions, e.g., no cracks or shrinkage become evident during UV exposure and repeated thermal bakes or environmental exposures. When shrinkage was measured substantially in accordance with ASTM D2453, the inventive composition had a shrinkage of about 0% when measured visually.

The inventive composition is a high cosmetic paintable material (a so-called Class A automotive). With proper application, the sealant provides excellent smoothness and gloss retention, e.g., the inventive sealant does not adversely impact the distinctiveness of image (DOI) of an overlying paint.

The inventive composition possesses an improved adhesion to conventional paint systems such as standard solvent based pigmented and clear systems, water based, latex, powder paints, automotive E-coats, mixtures thereof, among others. The inventive composition also possesses a desirable resistance to the ambient environment, e.g., twelve month Florida exposure testing in accordance with conventional testing methods has proven the inventive composition's durability as well as its resistance to mold/mildew growth, cracking and chalking. The inventive composition is also resistant to paint staining, fading and cracking as a result of Xenon Arc exposure.

The chemistry of the inventive composition allows the composition to be tailored to possess a wide variety of physical characteristics. By tailoring the constituent ratios of the composition the physical characteristics of the cured product will range from a flexible and relatively soft article to a hard sandable product. These characteristics can be obtained by varying the epoxy to polyol weight ratio e.g., the ratio can range from about 2:1 to about 4:1. Normally, an increased amount of epoxy will correspond to a harder cured coating. When the composition contains relatively large quantities of polyol, the hardness of the cured coating is reduced upon exposure to moisture, e.g, the Shore "A" Hardness when determined in accordance with conventional measuring techniques ranges from about 70 to at least about 95. The presence of relatively large quantities of polyol can, however, improve adhesion of the inventive composition to the underlying substrate.

The hardness of the composition is increased by including a phenoxy resin. While any suitable hardening resin can be employed, examples of suitable resins comprise at least one member selected from the group consisting of phenoxy resin, solid epoxy (in particulate form), mixtures thereof, among others. Normally, the amount of hardening resin corresponds to about 1 to about 9 wt. % of the composition prior to curing. By including such a hardening resin, the Shore "D" hardness of the composition, subsequent to curing, can range from about 60 to about 80. The hardening resin also improves the solvent and moisture resistance of the cured composition.

In addition, the viscosity of an uncured composition can be tailored by adjusting the silica to polymer ratio and/or the polyol ratio. The viscosity of the uncured composition can also be increased by introducing a solid epoxy in addition to or as a replacement for the aforementioned epoxies. Examples of suitable solid epoxies comprise at least one member selected from the group consisting of bis-Phenol A, novalac resin, mixtures thereof, among others. The viscosity can be tailored to be similar to paint, or increased to a grease or paste-like consistency. The presence of a solid epoxy can also be employed for imparting enhanced resistance to moisture.

The inventive composition, prior to curing, is about 98.5 to at least about 99.75 wt. % solids, e.g., about 99.5 wt. % solids. While the dimensional thickness of the inventive composition can be tailored to satisfy a wide range of end-uses, normally the composition is applied at a thickness of about 0.05mm to about 10 mm thick, e.g., in the case of roof ditch the composition is about 5mm thick. The ability of the inventive composition to form such relatively thick layers is in contrast to conventional practices and a marked improvement.

While the inventive composition is not adversely affected by most solvents, the composition can substantially reduce, if not eliminate, the presence of solvents, e.g., the inventive composition can be essentially volatile organic compound (VOC) free. That is, the uncured composition may include about 0.1 to about 1.0 wt. %, normally about 0.5 wt.%, of a solvent which functions as a carrier for the photoinitiator, e.g., about 0.50 wt.% propylene carbonate.

As described above, the inventive UV cured composition can be employed in a wide range of applications; especially in the automotive field. One such example comprises a roof ditch sealant which is a Class A paintable sealer. Once the inventive composition is applied, the composition is cured in situ by a source of concentrated UV light thereby permitting an "in-line" curing application. That is, a robotic arm can be a double functional tool, with both a dispensing nozzle for delivering the inventive composition into a roof ditch and the curing lamp attached in parallel. Alternatively, the curing lamp(s), e.g, one or more UV and infrared lamps, can be physically separate but operationally connected to the robot, e.g., the lamps are mounted above or beside the robot on a gantry wherein the movement/operation of the robot and lamps are controlled by computer. The inventive composition can be supplied to the robot arm by using any suitable pump such as a positive displacement reciprocating piston pump, e.g., model no. 711008-662-000 19 litre (5 gal) pump supplied by Graco Inc.

In one particular aspect of the aforementioned roof ditch application, a plurality of protrusions, studs or mechanical fastening means having any desirable shape can be located within and attached to the bottom of the ditch for enhancing the bond between the ditch and overlying UV cured composition. When studs are employed, the studs can be welded within the ditch when forming the underlying weld that forms the ditch, e.g, when welding the automotive roof and side body panels together. Any protrusions can also be affixed within the ditch by a suitable adhesive, or by mechanical attachment. The height and specific configuration of the protrusions depends upon the application: but, normally, the protrusions are about 3 to about 7 mm tall. These protrusions can be fabricated from any suitable material such as thermoplastics such as nylon, metal, among other materials. When introduced into the ditch, the inventive flowing composition embeds the protrusions, fills the ditch and can form a self-leveling surface. These protrusions can also be utilized in after-market applications when repairing or replacing a roof ditch sealant.

The configuration of the roof ditch can be tailored for improving the mechanical bond between the ditch and UV cured composition. For example, a ditch having trapezoidal cross-section can be employed. If desired, the previously described protrusions or studs can be employed within a tailored ditch configuration.

The inventive composition can also be applied upon non-planar surfaces. For example, the inventive composition can be employed as a Class A paintable automotive coach and coach joint sealant. Such joints can be on a horizontal or vertical surface. The ability of the inventive composition to be cured substantially simultaneously following application permits the composition to be employed on such vertical surfaces. In order to enhance vertical surface application, the viscosity of the inventive composition can be increased by adding about 3 to about 10 wt.% of a thickener such as CAB-O-SIL silica, polyether polyol, mixtures thereof, among others.

Moreover, the inventive composition can be employed for repairing dents and scratches in a painted surface, e.g., an automotive door. That is, the composition can be applied upon a surface, exposed to UV light, and, thereafter, sanded as needed and painted in accordance with conventional methods. Similarly, a two component system can be employed without using exposure to UV light. For example, a two component system based upon an interaction between an epoxy and acid can be combined, applied upon a surface as a gel, permitted to harden and adhere to the surface and, thereafter, prepared for painting by using conventional techniques. In some cases, the substrate being repaired and/or inventive composition can be heated to enhance adhesion to the substrate.

The inventive composition can be applied onto a wide range of substrates. The inventive composition can be employed in a method for applying one or more coatings upon an automotive surface. For example, an automotive assembly may be immersed within the inventive composition and, thereafter, cured by being exposed to UV radiation. Such an immersion may be employed, for example, as an enhancement or a replacement for conventional automotive E-coats. Once cured, the automotive assembly can be painted in accordance with conventional methods. Without wishing to be bound by any theory or explanation, it is believed that the composition may be tailored for application upon unpainted surfaces as a corrosion protectant, e.g., upon an automotive underbody, among other applications.

In one aspect of the invention, the inventive composition can be employed as an automotive brake rotor coating for imparting corrosion protection. The inventive composition can be applied via an aerosol or a spray upon the rotor to form a thin film coating. The resultant layer is sacrificial in that the layer is consumed or removed when contacted by the brake pad. In a related aspect, the inventive composition can be employed as a temporary corrosion protectant such as upon saw blades wherein friction or other usage of the protected article removes the coating. In such cases, it can be useful to add one or more surfactants, e.g., less than about 1.0 wt.% of Fluorad FC-171 fluorochemical available from 3M.

In another aspect of the invention, the inventive coating is employed as a Class B paintable coating. For example, the inventive coating is applied as a spray upon a metal substrate such a lower automotive body panel in order to form an antichip coating (so-called stoneguard). The inventive composition can also be sprayed upon the floor pan, roof, among other regions of an automobile during assembly for improving acoustics, among other properties.

In another aspect of the invention, the inventive composition can be mixed, molded, extruded or shaped into an article that is subsequently exposed to UV. If desired, the inventive composition can be co-extruded with another material thereby forming an article having a UV curable surface. While a wide range of articles can be formed, one example of such an article comprises automotive moldings. Such moldings can be fabricated and shipped to an automotive assembly plant, or extruded and cured directly on the automobile.

In a further aspect of the invention, the inventive composition is employed as a repair material for automotive coatings, seals, household applications, among other areas wherein it is desirable to have long-lasting, flexible and paintable sealants. For example, the inventive composition can be applied upon a substrate, cured with UV and exposed to infrared (IR) radiation for 90 seconds thereby forming a seal to repair a crack in the underlying substrate or coating.

The previously described compositions can be modified to obtain a gel consistency by adding a gelling agent. Examples of suitable gelling agents comprise at least one member selected from the group consisting of treated or untreated silica, detergents, polyether polyols, mixtures thereof, among others. When using a UV curable composition, the gelling agent should not adversely affect UV transmission through the composition. The gelling agent normally comprises about 0.5 to about 10 wt.% of an uncured compositions. By employing a gelling agent, the viscosity and handling characteristics of the inventive composition can be improved, e.g., the composition can be tailored to possess a putty or caulk-like consistency.

Moreover, the previously described compositions can be modified to obtain an acid or UV activated foam. Any suitable chemical or mechanical expansion agent can be added to these compositions. Examples of suitable chemical or mechanical expansion agent comprise at least one member selected from the group consisting of water, hydrazide, diphenyloxide-4,4-disulphohydrazide, hexamethylene diamine carbamate, carbonamide, azocarbonamide, sodium bicarbonate, carbon dioxide, fluorocarbons, encapsulated materials, e.g, Expancel® supplied by H.M. Royal; mixtures thereof, among others. The expansion agent normally comprises about 0.5 to about 10 wt.% of an uncured compositions. The expansion agent becomes activated by being exposed to either UV or a suitable source of heat, e.g, an exothermic reaction between an epoxy and acid. For example, when employing a UV curable composition and such a composition is exposed to UV light an exothermic reaction occurs that in turn causes the expansion agent to swell thereby increasing the volume of the composition. Similarly, when an acid activated composition is employed, the heat released when the acid contacts the epoxy causes the expansion agent to swell.

While the above description places particular emphasis upon applying the inventive composition within an automotive roof ditch, the inventive composition can be applied to a wide range of substrates. Examples of suitable substrates include at least one member of the group consisting of metals such as stainless steel, galvanized steel, concrete, cement, glass, wood, among others. In the case of metal substrates, the inventive composition can be applied upon a welded joint including a joint formed by spot, wire and laser welding.

The composition of the instant invention can be applied to a substrate by any suitable method. Such methods include brushing, immersing, pumping, dipping, painting, spraying, among other suitable conventional methods. When the inventive composition is applied upon the weld in an automotive roof ditch, it is desirable to pump the composition into and along the ditch. Because of its low viscosity at 25°C (77 °F) of the composition and thixotropic behavior, equipment such as a reciprocating piston (positive displacement) pump, gear pump, pneumatic tube (such as that supplied by SEMCO), caulking tube (hand trigger), air or airless spray, squeeze tube, brush, among other commercially available equipment, mav be used. The uncured composition may then be manipulated further, e.g., pressed or embossed, into a desired finish.

The inventive composition, once applied, is normally cured with a UV light source. This can be done immediately upon application to a substrate, or delayed depending upon the characteristics desired in the coated substrate. For example, by delaying UV cure the composition can be shaped, or leveled/smoothed to better conform to the underlying substrate. As aforementioned, the UV cure may be followed by a bake, or allowed to finish curing naturally. The sealed joint or coated substrate may now be painted or otherwise finished. If desired, one or more layers of compositions which are chemically similar or distinct can be applied upon a cured composition, e.g., two or more layers of UV cured composition can be applied sequentially or used to form a laminate structure.

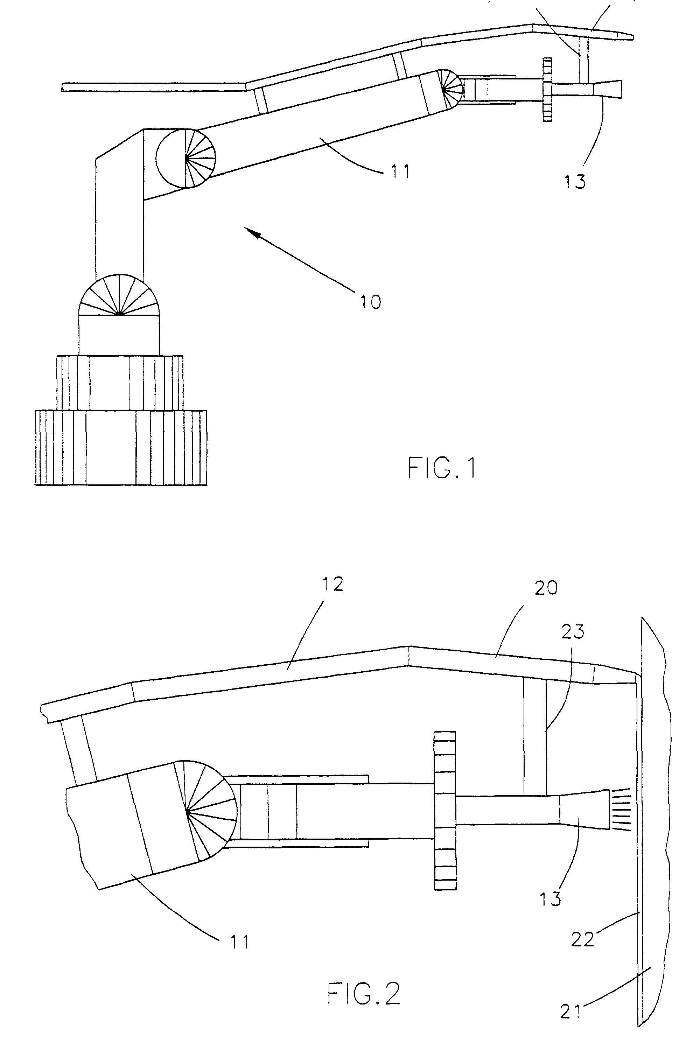

One method for applying the inventive composition is illustrated by the Drawings. Referring now to Figure 1, Figure 1 is a schematic diagram of a robotic means for applying the inventive composition; especially in automotive applications such as a roof-ditch sealant. Robot 10 includes arm 11 that supports conduit 12. Examples of robots include those supplied by Fanuc, Inc., Rochester Hills, Michigan, and ABB as ASEA Model 2000. A means for providing UV radiation 13 can be supported by robot arm 11. The operation and movement of robot 10 and arm 11 are controlled and monitored by commercial computer means (not shown). The inventive composition is supplied under pressure via conduit 12 to any desired location and in a virtually unlimited array of configurations. The light intensity from means 13 and fluid flow rate through conduit 12 are also controlled and monitored by commercially available computer means (not shown).

More details regarding one method for applying the inventive composition are shown by Figure 2. Referring now to Figure 2, conduit 12 is in fluid connection with dispensing or nozzle means 20. The inventive composition is dispensed from nozzle means 20 and applied upon a surface 21 thereby forming coating or seal 22. The thickness and configuration of seal 22 are determined by the pressure within conduit 12 and movement of arm 11. Substantially immediately after being dispensed, the composition is exposed to UV radiation from lamp means 13. The lamp means 13 and dispensing nozzle 20 are in fixed spatial relationship by connecting means 23 that is in turn affixed to arm 11. The UV exposed seal 22 is at least partially cross-linked or cured thereby forming a self-supporting seal 22. While the entire thickness of seal 22 may not be cured, the cured portion of seal 22 is adequate to prevent the seal 22 from fluid flow. Uncured portions, if any, of seal 22 can become cured during subsequent heat treatments, e.g., if the seal 22 comprises a roof ditch then residual curing will occur when exposed to high temperature painting processes.

The following Examples are provided to illustrate not limit the scope of the invention as defined by the appended claims. Unless indicated otherwise, the materials and equipment discussed below are commercially available.
3) Vacuum
4) Heated Liquid Pump
5) Unheated Liquid Pump
6) Weight Scale
7) Shipping Container Filling Equipment (Tube, Pail, or Drum)

Blending began by pumping into the mixing vessel polyester polyol 21°C (Dynacoll 7110) at 121°C (250 F). 70 kg (One-hundred fifty-four pounds) of a second polyester polyol (Tone 0301) was added to the mixing vessel. The polyols were blended until both polyol constituents are fully dissolved in each other. The polyol mixture is substantially transparent. The temperature within the mixing vessel was maintained at 82°C (180 F).

61kg (One-hundred thrity-five pounds) of cyclaliphatic epoxy (Uvacure 1500) was then added to the mixing vessel. When all of the epoxy was uniformly mixed 1.5 kg (3.3 pounds) of sulfonium salt (UVI-6974) were added to the vessel. Mixing was continued at a temperature of 82°C (180 F) for 10 min.

Eleven pounds of silica (Cab-O-Sil) was then added to the mixing vessel. The silica was stirred into the mixture until wetted. Then another 5 kg (11 pounds) of silica (Cab-O-Sil) is added. Mixing was continued to fully dispersed the constituents of the vessel. Mixing was then performed at high shear rate under vacuum until substantially no lumps and no air bubbles were visible. It was important to eliminate all air bubbles, for they may cause a discontinuity in the delivery line during customer application, and therefore an undesirable inconsistent delivery.

When vacuuming was completed, the resultant mixture was warm and clear with a consistency of syrup. When the batch is cooled and the shear stresses diminished, the mixture was thickened to a near gel state while maintaining clarity. For best results, shipping or storage containers should filled prior to cooling.

After the containers are filled and material cooled, specific gravity and viscosity checks should be performed to insure batch quality. For best results and in order to avoid premature curing of the composition, all storage and shipping containers should be opaque or shielded from UV sources including sunlight and fluorescent lighting. Such exposure could result in cure initiation thereby preventing the contents from being pumped.

### EXAMPLE 2

One inventive composition was produced in accordance with the following method. A 7.5 litre two (2) gallon Ross Model PD2 planetary dispersion mixer was obtained and in connected to a Chromolox heater. The dispersion mixer was operated at a temperature of 88°C (190 F).

2824 grams of liquid polyol (Tone 0301) and 888 grams of the solid polyol (7110) were introduced into the mixer and mixed for 10 minutes. Sixty (60) percent (240 grams) of the silica thickener (Cabosil supplied by Cabot Corporation) was introduced into the mixer and the combination was mixed for another 10 minutes.

500 grams of epoxy (Uvacure 1500) and the remaining 40% (160 grams) of the silica were then added and mixed for 10 min. This was followed by adding 60 grams of the photoiniatitor (Cyracure 6974) and 2172 grams of epoxy (UVACure 1500) to the mixer and mixed for 5 minutes. The contents of the mixer were then mixed under vacuum for 10 minutes thereby producing 4.9 litres (1.3 gallons) of the inventive composition.

### EXAMPLE 3

222g of polyester polyol (Dynacoll 7110) at a temperature of 121°C (250 F)were poured into the a gallon can. About 706g of a second polyester polyol (Tone 0301) were added to the first polyol. The polyols were blended in a Rotor-Stator Mixer. This until both constituents are fully dissolved in each other. The mixture was transparent at this point. The temperature of this mixture was maintained at 82°C (180 F).

Approximately 618g epoxy (Uvacure 1500) were admixed with the heated mixture. When all epoxy was uniformly mixed, 15g of photoiniator (UVI-6974) were added. Mixing continued at a temperature of 82°C (180 F) for 10 min.

To the mixture, about 50g of silica (Cab-O-Sil) were added. The mixture was stirred until the silica was wetted into the mix. An addition 50g of silica (Cab-O-Sil) was combined with the mixture while continuing mixing until the silica was fully dispersed.

The mixture was transferred to a vacuum chamber and maintained under vacuum until all bubbling ceased in the mixture. About 1.9 litres (½ gallon) of the inventive composition was obtained.

### EXAMPLE 4

The composition described by Examples 2 and 3 was applied to a metal substrate and cured in accordance with the instant Example. An ASEA Model 2000 Robot having a movable arm was employed to control the position of a SEMCO Dispensing tube. Movement of the arm was controlled by a ASEA (ABB) computer and software. Approximately 340 g (12 oz) of the inventive composition was applied at 275 kPa (40 psig) via a Pyles High Flow Robot Gun that was mounted on the robot arm. The composition was dispensed through a round nozzle, approx. 1cm. in diameter and cured subsequently by a shuttered UV lamp (1600 watt lamp) that was also attached to robot arm. A schematic drawing of this system is shown by aforementioned Figures 1 and 2.

The inventive composition was also applied from the robot arm by using a Pyles 19 litre (5 gal.) unheated pump (instead of the SEMCO tube), to supply the composition. A Pyles "snuff back" gun Model #12000 series was also substituted

### EXAMPLE 1

A UV curable composition comprising the following components was prepared:

| COMPONENT | Trade Name | Supplier |
|---|---|---|
| Wt.% | | |
| Cycloaliphatic Epoxy | Uvacure 1534 | UCB Radcure |
| 87 | | |
| Polyester Polyol | Dynacoll 7250 | Huls America |
| 4 | | |
| Phenoxy Resin | PKHM 85 | Phenoxy Specialties |
| 4 | | |
| Silicon Dioxide | Cab-O-Sil | Cabot |
| 4 | | |
| Sulfonium Salt | Cyracure UVI 6974 | Union Carbide |
| 1 | | |

The composition was prepared in a Ross DB-2 mixer and in accordance with the following method:

| | | | | |
|---|---|---|---|---|
| 1. | Add | 5405 grams of 1534 | Set temp. to 82°C (180°F) | Mix in the Ross Mixer for 10 minutes at lowest speed setting. |
| | | 260 grams of Cabosil | | |
| | | | | |
| 2. | Add | 270 grams of PKHM 85 | Temp. at 82°C (180°F) | Mix for 20 minutes at lowest speed setting. |
| | | 270 grams of 7250 | | |
| | | | | |
| 3. | Add | 56 grams of 6974 | Temp, at 82°C (180°F) | Mix under vacuum for 20 minutes at lowest speed setting. |

The temperature used for mixing can range from about 66°C (150°F) to at least about 88°C (190°F). Acceptable results can also be obtained from formulations that contain about 75 to about 95 wt.% epoxy and up to about 10 wt.% polyol and resin.

### EXAMPLE 2

A UV curable composition comprising the following components was prepared:

| COMPONENT | Trade Name | Supplier | Wt. % |
|---|---|---|---|
| Cycloaliphatic Epoxy | Uvacure 1500 | UCB Radcure | 45 |
| Polyester Polyol | Tone 0301 | Union Carbide | 29 |
| Polyester Polyol | Dynacoll 7250 | Huls America | 12 |
| Phenoxy Resin | PKHP 200 | Phenoxy Specialties | 5 |
| Polybutadiene | Poly BD 605 | Elf Atochem | 6 |
| Silicon Dioxide | Cab-O-Sil | Cabot | 2 |
| Sulfonium Salt | Cyracure UVI 6974 | Union Carbide | 1 |

The composition was combined in a Ross DB-2 mixer and in accordance with the following method:

| | | | | |
|---|---|---|---|---|
| 1. | Add | 2683 grams of 1500 | Set temp. to 121°C (250°F) | Mix for 60 minutes at lowest speed setting. |
| | | 1747 grams of Tone 0301 | | |
| | | 312 grams of PKHP 200 | | |
| | | | | |
| 2. | Add | 686 grams of 7250 | Temp. at 93°C (200°F) | Mix for 20 minutes at lowest speed setting. |
| | | 375 grams of Poly BD 605 | | |
| | | 125 grams of Cabosil | | |
| | | | | |
| 3. | Add | 56 grams of 6974 | Temp. at 66°C (150°F) | Mix under vacuum for 20 minutes at lowest speed setting. |

### EXAMPLE 3

This Example illustrates using a robotic means for applying a UV curable material within an automotive roof ditch in order to seal the underlying weld. The UV curable composition of Example 1 was dispensed into an automotive roof ditch by a computer controlled robot by using a Pyles 19 litre (5 gallon), reciprocating piston, positive displacement pump, SECO temperature controlled metering system and snuff back robot gun. Two robots were used for this application trial: a) Fanuc model F500 was employed to dispense the composition into the ditch and b) a Fanuc model 4201 was employed to transport a UV light source along the ditch to cure the composition. The UV light source comprised a Fusion Systems model T-6 1270 watts per cm (500 watts/inch) 15 cm, (6 inch) bulb, H type, mounted on the arm of the model 420i so that the UV bulb ran parallel to ditch. The composition was dispensed at a rate of 250mm/sec and the UV light was passed over the dispensed composition at a rate of 250mm/sec; for a total application and cure time of 30 seconds. The material was applied at ambient temperatures. The following process steps were used to dispense and cure the composition:
1 Cure robot start position was directly behind a "D" pillar end of the roof ditch with UV light on.
2. The dispensing robot moved to an initial position (positioned 3 to 5mm directly above the ditch) approximately 46 cm (18 inches) in front of the end of the ditch (between D and C pillar).
3. The UV curable composition was applied into the ditch moving toward the D pillar. Material was applied to within 8 to 15 mm of the end of the ditch, at which time the dispensing robot moves up and away from the ditch.
4. The cure robot immediately started moving along the length of the ditch starting at the D pillar and moving forward. Meanwhile, the dispensing robot moved back to its original starting point (3 to 5mm directly above the ditch approximately 46 cm (18 inches) in front of the end of the ditch) and applied material in the ditch while moving forward.
5. At this point, both robots moved in tandem forward along the ditch. The distance between the dispensing gun and lamp housing was approximately 15-20 cm (6 to 8 inches).
6. The dispensing robot applied material in the ditch to within 8 to 15mm of the front of the ditch (A pillar) and immediately moved up and away from the ditch.
7. The cure robot continued movement to the front of the ditch (A pillar) and immediately reversed direction, traveling back the entire length of the ditch and stopping at its original start position
8. The UV light was turned off and a self-supporting layer was formed in the ditch.

## Claims

1. A radiation curable composition comprising a combination of at least one liquid cationic curing epoxy, at least one polyol, at least one thickener, at least one photoinitiator and at least one phenoxy resin.

2. The composition of claim 1 wherein the thickener comprises silica.

3. The composition of claim 1 or 2 wherein the ratio of epoxy to polyol is 1:1 to 2.1.

4. The composition of claim 1, claim 2 or claim 3 wherein said at least one polyol is a polyester polyol.

5. The composition of any one of claims 1 to 4 wherein said at least one polyol comprises at least one polyester polyol and at least one polyether polyol.

6. The composition of any one of claims 1 to 5 wherein the photoinitiator comprises a sulfonium salt.

7. The composition of any one of claims 1 to 6 further comprising at least one expansion agent and/or gelling agent.

8. The composition of claim 7 wherein the expansion agent is encapsulated.

9. The composition of any one of claims 1 to 8 further comprising at least one sulfonic acid, phosphoric acid, carboxylic acids or tannic acid.

10. The composition of any preceding claim further comprising polybutadiene.

11. The composition of any preceding claim further comprising at least one surfactant

12. The composition of any preceding claim wherein said epoxy ranges from 45 to 60 wt.% of the composition.

13. The composition of any preceding claim further comprising bis-phenol A epoxy.

14. The composition of any preceding claim wherein the amount of thickener is sufficient to obtain a composition having a viscosity of 20,000 to 80,000 centipose.

15. The composition of any preceding claim wherein the at least one epoxy comprises at least one cycloaliphatic epoxy.

16. Use of the composition of any one of claims 1 to 15 to form a painted article, layer or seal having a Shore D Hardness of greater than 70, and an ASTM D2453 shrinkage of about 0%.

17. A method for treating an automotive surface comprising,
providing an automotive surface,
applying a composition as claimed in any one of claims 1 to 15 onto said automotive surface,
exposing the composition to a source of radiation comprising UV radiation sufficient to cause cross linking,
heating said cross-linked composition,
painting the composition.

18. A method for sealing automotive surfaces comprising,
applying a composition as claimed in any one of claims 1 to 15 onto said, automotive surface,
exposing the composition to a source of radiation comprising UV radiation sufficient to cause cross linking painting the composition.

19. A method for repairing or protecting a painted automotive surface comprising:
providing a painted automotive surface,
applying a composition as claimed in any one of claims 1 to 15 onto said painted automotive surface as a spray or gel,
exposing the composition to a source of radiation comprising UV radiation sufficient to cause cross linking painting the composition and said component.

20. The method of claim 19 in which the composition is sanded prior to the painting.

21. The method of claim 17, 18, 19 or 20 wherein said source of radiation comprises ultra violet light, preferably having a wavelength of 250 to 400nm.

22. The method of claim 18, wherein said heating is at a temperature and length of time sufficient to improve the adhesion of said at least partially cross-linked composition, the method further comprising heating the composition after radiation exposure and prior to painting.

23. The method of claim 17 or 18 wherein said applying comprises at least one of spraying, pumping, brushing, immersing and robotic means.

24. The method of any one of claims 17 to 23 wherein said automotive component comprises a roof ditch.

## Patentansprüche

1. Strahlungshärtbare Zusammensetzung, umfassend eine Kombination aus mindestens einem flüssigen kationischen Härtungsepoxidharz, mindestens einem Polyol, mindestens einem Verdickungsmittel, mindestens einem Photoinitiator und mindestens einem Phenoxyharz.

2. Zusammensetzung nach Anspruch 1, wobei das Verdickungsmittel Siliciumdioxid umfasst.

3. Zusammensetzung nach Anspruch 1 oder 2, wobei das Verhältnis von Epoxidharz zu Polyol 1:1 bis 2:1 ist.

4. Zusammensetzung nach Anspruch 1, Anspruch 2 oder Anspruch 3, wobei das mindestens eine Polyol ein Polyesterpolyol ist.

5. Zusammensetzung nach einem der Ansprüche 1 bis 4, wobei das mindestens eine Polyol mindestens ein Polyesterpolyol und mindestens ein Polyetherpolyol umfasst.

6. Zusammensetzung nach einem der Ansprüche 1 bis 5, wobei der Photoinitiator ein Sulfoniumsalz umfasst.

7. Zusammensetzung nach einem der Ansprüche 1 bis 6, des weiteren umfassend mindestens ein Schäumungsmittel und/oder Geliermittel.

8. Zusammensetzung nach Anspruch 7, wobei das Schäumungsmittel verkapselt ist.

9. Zusammensetzung nach einem der Ansprüche 1 bis 8, des weiteren umfassend mindestens eine Sulfonsäure, Phosphorsäure, Carbonsäuren oder Tannin.

10. Zusammensetzung nach einem der vorangehenden Ansprüche, des weiteren Polybutadien umfassend.

11. Zusammensetzung mach einem der vorangehenden Ansprüche, die zusätzlich mindestens ein oberflächenaktives Mittel umfasst.

12. Zusammensetzung nach einem der vorangehenden Ansprüche, wobei das Epoxidharz von 45 bis 60 Gewichtsprozent der Zusammensetzung ausmacht.

13. Zusammensetzung nach einem der vorangehenden Ansprüche, des weiteren ein Bisphenol-A-Epoxidharz umfassend.

14. Zusammensetzung nach einem der vorangehenden Ansprüche, wobei die Menge des Verdickungsmittels ausreicht, eine Zusammensetzung mit einer Viskosität von 20.000 bis 80.000 Centipose zu erreichen.

15. Zusammensetzung nach einem der vorangehenden Ansprüche, wobei mindestens ein Epoxidharz mindestens ein cycloaliphatisches Epoxidharz umfasst.

16. Verwendung der Zusammensetzung nach einem der Ansprüche 1 bis 15 zur Ausbildung eines lackierten Artikels, einer Schicht oder einer Dichtung mit Shore-D-Härte größer 70 und einem Schwund gemäß ASTM D2453 von etwa 0%.

17. Verfahren zur Behandlung einer Kraftfahrzeugoberfläche, umfassend Bereitstellung einer Kraftfahrzeugoberfläche,
Auftragen einer Zusammensetzung gemäß einem der Ansprüche 1 bis 15 auf die Kraftfahrzeugoberfläche,
Exponierung der Zusammensetzung an einer eine UV-Strahlung umfassenden Strahlungsquelle, die ausreicht, eine Vernetzung auszulösen, Erhitzung der vernetzten Zusammensetzung,
Auflackieren der Zusammensetzung.

18. Verfahren zur Abdichtung von Kraftfahrzeugoberflächen, umfassend Auftragen einer Zusammensetzung gemäß einem der Ansprüche 1 bis 15 auf die Kraftfahrzeugoberfläche,
Exponierung der Zusammensetzung an einer eine UV-Strahlung umfassenden Strahlungsquelle, die ausreicht, eine Vernetzung auszulösen, Auflackieren der Zusammensetzung.

19. Verfahren zur Reparatur oder zum Schutz einer lackierten Kraftfahrzeugoberfläche, umfassend:
Bereitstellen einer lackierten Kraftfahrzeugoberfläche,
Auftragen einer Zusammensetzung nach einem der Ansprüche 1 bis 15 auf die lackierte Kraftfahrzeugoberfläche als Spray oder Gel,
Exponieren der Zusammensetzung an einer eine UV-Strahlung umfassenden Strahlungsquelle, die ausreicht, eine Vernetzung zu bewirken,
Lackieren der Zusammensetzung und der Komponente.

20. Verfahren nach Anspruch 19, in dem die Zusammensetzung vor dem Lackieren abgeschliffen wird.

21. Verfahren nach Anspruch 17, 18, 19 oder 20, wobei die Strahlungsquelle Ultraviolettlicht umfasst, vorzugsweise mit einer Wellenlänge von 250 bis 400 nm.

22. Verfahren nach Anspruch 18, wobei die Erhitzung auf eine Temperatur und über eine Dauer erfolgt, die ausreichen, die Adhäsion der mindestens teilweise vernetzten Zusammensetzung zu verbessern, wobei das Verfahren des weiteren das Erhitzen der Zusammensetzung nach Strahlenexponierung und vor dem Auflackieren umfasst.

23. Verfahren nach Anspruch 17 oder 18, wobei das Auftragen mindestens eines von Aufsprühen, Pumpen, Malen, Tauchen und Robotermittel umfasst.

24. Verfahren nach einem der Ansprüche 17 bis 23, wobei die Kraftfahrzeugkomponente eine Dachrinne (Roof-Ditch) umfasst.

## Revendications

1. Composition durcissable par irradiation comprenant une combinaison d'au moins un époxy liquide à durcissement cationique, au moins un polyol, au moins un épaississant, au moins un amorceur photochimique et au moins une résine phénoxy.

2. Composition selon la revendication 1, dans laquelle l'épaississant comprend de la silice.

3. Composition selon la revendication 1 ou 2, dans laquelle le rapport époxy/polyol est 1/1 à 2/1.

4. Composition selon la revendication 1, la revendication 2 ou la revendication 3, dans laquelle ledit au moins un polyol est un polyester polyol.

5. Composition selon l'une quelconque des revendications 1 à 4, dans laquelle ledit au moins un polyol comprend au moins un polyester polyol et au moins un polyéther polyol.

6. Composition selon l'une quelconque des revendications 1 à 5, dans laquelle l'amorceur photochimique comprend un sel de sulfonium.

7. Composition selon l'une quelconque des revendications 1 à 6, comprenant en outre au moins un agent expansif et/ou un gélifiant.

8. Composition selon la revendication 7, dans laquelle l'agent expansif est encapsulé.

9. Composition selon l'une quelconque des revendications 1 à 8, comprenant en outre au moins un acide sulfonique, un acide phosphorique, des acides carboxyliques ou un acide tannique.

10. Composition selon l'une quelconque des revendications précédentes, comprenant en outre du polybutadiène.

11. Composition selon l'une quelconque des revendications précédentes, comprenant en outre au moins un tensioactif.

12. Composition selon l'une quelconque des revendications précédentes, dans laquelle ledit époxy représente 45 à 60 % en poids de la composition.

13. Composition selon l'une quelconque des revendications précédentes, comprenant en outre un époxy à base de bisphénol A.

14. Composition selon l'une quelconque des revendications précédentes, dans laquelle la quantité d'épaississant suffit pour obtenir une composition ayant une viscosité allant de 20 000 à 80 000 centipoises.

15. Composition selon l'une quelconque des revendications précédentes, dans laquelle le au moins un époxy comprend au moins un époxy cyclo-aliphatique.

16. Utilisation de la composition selon l'une quelconque des revendications 1 à 15 pour former un article, une couche ou un joint peint(e) ayant une dureté Shore D supérieure à 70, et un retrait selon la norme ASTM D-2453 à peu près nul.

17. Procédé pour traiter une surface d'automobile comprenant :
la fourniture d'une surface d'automobile,
l'application d'une composition selon l'une quelconque des revendications 1 à 15 sur ladite surface d'automobile,
l'exposition de la composition à une source d'irradiation comprenant un rayonnement UV suffisant pour entraîner une réticulation,
le chauffage de ladite composition réticulée,
le peinturage de la composition.

18. Procédé pour sceller des surfaces d'automobile comprenant :
l'application d'une composition selon l'une quelconque des revendications 1 à 15 sur ladite surface d'automobile,
l'exposition de la composition à une source d'irradiation comprenant un rayonnement UV suffisant pour entraîner une réticulation,
le peinturage de la composition.

19. Procédé pour réparer ou protéger une surface d'automobile peinte comprenant :
la fourniture d'une surface d'automobile peinte,
l'application d'une composition selon l'une quelconque des revendications 1 à 15 sur ladite surface d'automobile peinte sous forme de spray ou de gel,
l'exposition de la composition à une source d'irradiation comprenant un rayonnement UV suffisant pour entraîner une réticulation,
le peinturage de la composition et dudit composant.

20. Procédé selon la revendication 19, dans lequel la composition est poncée avant peinturage.

21. Procédé selon la revendication 17, 18, 19 ou 20, dans lequel ladite source d'irradiation comprend la lumière ultraviolette, ayant de préférence une longueur d'onde de 250 à 400 nm.

22. Procédé selon la revendication 18, dans lequel ledit chauffage s'effectue à une température et pendant une durée suffisantes pour améliorer l'adhérence de ladite composition au moins partiellement réticulée, le procédé comprenant en outre le chauffage de la composition après exposition à l'irradiation et avant peinturage.

23. Procédé selon la revendication 17 ou 18, dans lequel ladite application comprend au moins un moyen parmi des moyens de pulvérisation, de pompage, d'application au pinceau, d'immersion et robotiques.

24. Procédé selon l'une quelconque des revendications 17 à 23, dans lequel ledit composant automobile comprend une gouttière de toit.
